# EUROPEAN PATENT APPLICATION

(11) **EP 2 096 682 A1**
(43) Date of publication of application: **02.09.2009**
(21) Application number: 09250561.9
(22) Date of filing: 27.02.2009
(51) Int. Cl.: H01L 31/05

(54) **Solar cell module and method for manufacturing the same**

(30) Priority: 27.02.2008 JP 2008045337; 06.02.2009 JP 2009026653
(71) Applicant: SANYO Electric Co., Ltd., Moriguchi-shi Osaka 570-8677 (JP)
(72) Inventor: Kannou, Hiroyuki , Sanyo Electric Co., Ltd., Moriguchi-shi, Osaka 570-8677 (JP); Nakatani, Shihomi , Sanyo Electric Co., Ltd., Moriguchi-shi, Osaka 570-8677 (JP); Ninomiya Kunimoto , Sanyo Electric Co., Ltd., Moriguchi-shi, Osaka 570-8677 (JP)
(74) Representative: Calderbank, Thomas Roger

(57) **Abstract**

Provided is a solar cell module capable of improving manufacturing yields, and a method for manufacturing the solar cell module. The solar cell module includes: first and second solar cells; a first-surface-side connecting member bonded to a first-surface-side electrode of each solar cell with a conductive adhesive member; and a second-surface-side connecting member bonded to a second-surface-side electrode of each solar cell with the conductive adhesive member. One connecting member has an exposed surface, on which no conductive adhesive member is applied, on a surface facing a space Sα sandwiched between the first and second solar cells.

## Description

The present invention relates to a solar cell module including not less than two solar cells electrically connected in parallel to each other, and a method for manufacturing the solar cell module.

Heretofore, a solar cell module including a plurality of solar cells electrically connected in parallel to each other have been known (for example, see Japanese Patent Application Publication No. 2003-086819).

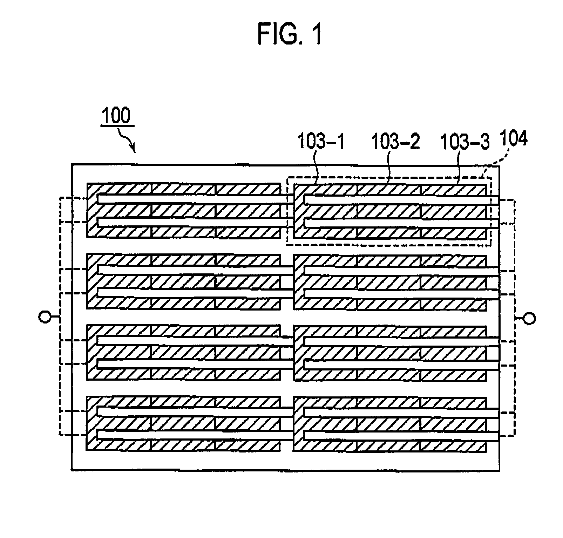

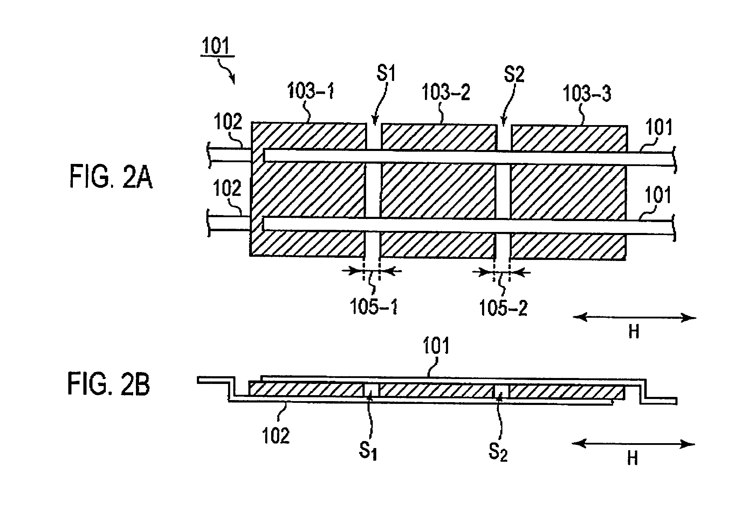

Fig. 1 is a schematic plane view of such a conventional solar cell module. Figs. 2A and 2B are explanatory views for explaining a connection structure between the solar cells. Fig. 2A is a schematic plane view, and Fig. 2B is a schematic side view.

As shown in Fig. 1, a conventional solar cell module 100 includes a plurality of solar cell groups 104 each having three solar cells 103-1, 103-2, and 103-3 electrically connected in parallel to each other. The plurality of solar cell groups 104 is electrically connected to each other in series.

As shown in Figs. 2A and 2B, the solar cell 103-1 and the solar cell 103-2 are arranged at a predetermined interval 105-1. A space S1 is formed between the solar cell 103-1 and the solar cell 103-2. Similarly, the solar cell 103-2 and the solar cell 103-3 are arranged at a predetermined interval 105-2. A space S2 is formed between the solar cell 103-2 and the solar cell 103-3.

The solar cells 103 are electrically connected in parallel to each other by surface-side connecting members 101 and back-surface-side connecting members 102. Specifically, each surface-side connecting member 101 is soldered onto a surface-side electrode (not shown) provided on the surface of each solar cell 103. Similarly, each back-surface-side connecting member 102 is soldered onto a back-surface-side electrode (not shown) provided on the back surface of each solar cell 103. Generally, for the surface-side connecting member 101 and the back-surface-side connecting member 102, a sheet of copper whose surface is covered with solder is used.

Here, the surface-side connecting member 101 and the back-surface-side connecting member 102 are disposed to face each other with the spaces S1 and S2 in between. For this reason, when the surface-side connecting member 101 and the back-surface-side connecting member 102 are soldered, melted solder may flow into the spaces S1 and S2. In such a case, there has been a problem that short circuit and leak may be caused between the connecting members, between each connecting member and each solar cell 103, or between the solar cells 103. Such short circuit or leak may result in reduction in an output of the solar cell module and manufacturing yields.

The present invention may provide a solar cell module capable of suppressing reduction in an output of the solar cell module and improving manufacturing yields, and a method for manufacturing the solar cell module.

A solar cell module according to the present invention includes: first and second solar cells each having a main surface and an electrode formed on the main surface; and a connecting member disposed to extend across the respective electrodes of the first and second solar cells. In the solar cell module, the connecting member is bonded to the respective electrodes of the first and second solar cells through a conductive adhesive layer, and the conductive adhesive layer is not formed on a facing surface which is a region of a surface of the connecting member, the facing surface facing a space sandwiched between the first and second solar cells.

In the solar cell module according to the present invention, the facing surface may be exposed to the space.

In the solar cell module according to the present invention, the facing surface may be covered with a member having a melting point higher than that of the conductive adhesive member.

In the solar cell module according to the present invention, the conductive adhesive layer is formed by melting and solidifying a conductive adhesive member, and the conductive adhesive member formed on the facing surface does not have to be melted and solidified.

Preferably, the connecting member includes: a first member disposed on the electrode of the first solar cell; a second member disposed on the electrode of the second solar cell; and a third member disposed to extend across the first and second members. In the solar cell module, the third member is bonded to the first and second members through a conductive adhesive layer formed on surfaces of the first and second members, and the facing surface may be a region of a surface of the third member, the region facing the space.

The solar cell module according to the present invention may further include a protective member disposed at the main surface side of each of the first and second solar cells. In the solar cell module, the protective member may have flexibility.

A method for manufacturing a solar cell module according to the present invention includes the steps of: arranging first and second solar cells at a predetermined interval, each of the first and second solar cells having a main surface and an electrode formed on the main surface; disposing a connecting member through a conductive adhesive member so as to extend across the respective electrodes of the first and second solar cells; and bonding the connecting member to the respective electrodes of the first and second solar cells through a conductive adhesive layer formed by melting and solidifying the conductive adhesive member. In the method, in the bonding step, the conductive adhesive layer is not formed on a facing surface which is a region of a surface of the connecting member, the facing surface facing a space sandwiched between the first and second solar cells.

The method for manufacturing a solar cell module according to the present invention may further include a step of exposing the facing surface by removing the conductive adhesive member disposed on the facing surface before the bonding step.

In the method for manufacturing a solar cell module according to the present invention, in the bonding step, an facing part of the connecting member facing the space does not have to be directly heated.

In the method for manufacturing a solar cell module according to the present invention, in the bonding step, a heat-absorbing member may be thermally coupled to the facing part.

In the method for manufacturing a solar cell module according to the present invention, the arranging step includes the steps of; disposing a first member through a conductive adhesive member on the electrode of the first solar cell; disposing a second member through the conductive adhesive member on the electrode of the second solar cell; and disposing a third member through the conductive adhesive member on the first and second members; and in the bonding step, the facing surface may be a region of a surface of the third member, the region facing the space.

The method for manufacturing a solar cell module according to the present invention may further include a step of disposing a protective member having flexibility through a sealing member at the main surface side of each of the first and second solar cells after the bonding step.

IN THE DRAWINGS:
Fig. 1 is a plane view of a conventional solar cell module;
Figs. 2A and 2B are explanatory views of a conventional solar cell group;
Fig. 3 is an enlarged side view of a solar cell module according to a first embodiment of the present invention;
Figs. 4A and 4B are plane views of a solar cell according to the first embodiment;
Figs. 5A and 5B are plane views of a solar cell group according to the first embodiment;
Fig. 6 is an enlarged side view of a solar cell group according to a modification of the first embodiment;
Fig. 7 is an enlarged side view of a solar cell group according to a second embodiment of the present invention;
Fig. 8 is an explanatory view for explaining a manufacturing process of the solar cell group according to the second embodiment;
Fig. 9 is an explanatory view for explaining a manufacturing process of a solar cell group according to a modification of the second embodiment; and
Fig. 10 is an enlarged side view of a solar cell group according to a third embodiment of the present invention.

Next, embodiments of the present invention will be described with reference to the drawing. In the description of the drawings below, the same or similar reference numerals are given to the same or similar parts. However, it should be noted that the drawings are merely schematic and a dimensional ratio and the like thereof are different from actual ones. Accordingly, specific dimensions and the like should be determined in consideration of the description below. Moreover, needless to say, there are differences in dimensional relationships and ratios among the drawings.

### [First embodiment]

### (Schematic Structure of Solar Cell Module)

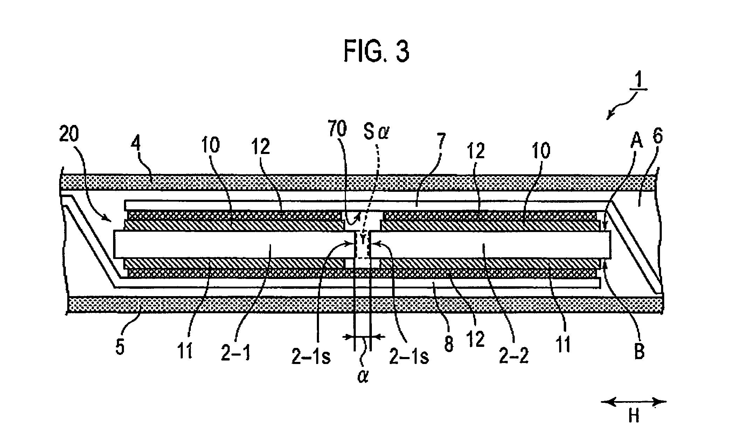

With reference to Fig. 3, description will be given of a schematic structure of a solar cell module according to a first embodiment of the present invention. Fig. 3 is an enlarged side view of the solar cell module according to this embodiment.

A solar cell module 1 includes a solar cell group 20, a first-surface-side protective member 4, a second-surface-side protective member 5, and a sealing member 6. The solar cell module 1 is formed by sealing the solar cell group 20 with the sealing member 6 between the first-surface-side protective member 4 and the second-surface-side protective member 5. Although not shown, a plurality of solar cell groups 20 is arranged in an arrangement direction H.

Each solar cell group 20 includes two solar cells 2 arranged in the arrangement direction H. In the description below, one solar cell 2 is referred to as a first solar cell 2-1, and the other solar cell 2 is referred to as a second solar cell 2-2. The solar cell group 20 is formed by electrically connecting the first and second solar cells 2-1 and 2-2 in parallel to each other by using a first-surface-side connecting member 7 and a second-surface-side connecting member 8.

The first and second solar cells 2-1 and 2-2 are arranged with a predetermined interval α in between. A space Sα is formed between the first and second solar cells 2-1 and 2-2. In other words, the space Sα is a space sandwiched between a side surface 2-1s facing the second solar cell 2-2 of the first solar cell 2-1, and a side surface 2-2s facing the first solar cell 2-1 of the second solar cell 2-2.

Each of the first and second solar cells 2-1 and 2-2 has a first surface A and a second surface B provided on the opposite side of the first surface A. Note that the first and second surfaces A and B are main surfaces of the first and second solar cells 2-1 and 2-2, respectively. In the first and second surfaces A and B, one surface is a light-receiving surface that receives sunlight, and the other surface is a back surface. The first and second surfaces A and B are formed by a photoelectric conversion part 30 to be described later. A first-surface-side electrode 10 is formed on the first surface A of each solar cell 2, and a second-surface-side electrode 11 is formed on the second surface B of each solar cell 2.

The first-surface-side connecting member 7 electrically connects the respective first-surface-side electrodes 10 of the first and second solar cells 2-1 and 2-2 to each other. Specifically, the first-surface-side connecting member 7 is disposed to extend across the first-surface-side electrode 10 of the first solar cell 2-1 and the first-surface-side electrode 10 of the second solar cell 2-2. The first-surface-side connecting member 7 is electrically connected to each of the first-surface-side electrodes 10 through a conductive adhesive layer 12. The first-surface-side connecting member 7 is formed of a low resistive element (copper, etc.) molded into a shape such as a thin plate or a twisted line.

The second-surface-side connecting member 8 electrically connects the respective second-surface-side electrodes 11 of the first and second solar cells 2-1 and 2-2 to each other. Specifically, the second-surface-side connecting member 8 is disposed to extend across the second-surface-side electrode 11 of the first solar cell 2-1 and the second-surface-side electrode 11 of the second solar cell 2-2. The second-surface-side connecting member 8 is electrically connected to each of the first-surface-side electrodes 10 through the conductive adhesive layer 12. The second-surface-side connecting member 8 is also formed of a low resistive element (copper, etc.) molded into a shape such as a thin plate or a twisted line.

The conductive adhesive layer 12 is provided on a surface of the first-surface-side connecting member 7 so as to face each of the first and second solar cells 2-1 and 2-2. The conductive adhesive layer 12 bonds the first-surface-side connecting member 7 and the first-surface-side electrode 10. Moreover, the conductive adhesive layer 12 is provided on a surface of the second-surface-side connecting member 8 so as to face each of the first and second solar cells 2-1 and 2-2. The conductive adhesive layer 12 bonds the second-surface-side connecting member 8 to the second-surface-side electrode 11.

The conductive adhesive layer 12 is made of a conductive material such as solder. The conductive adhesive layer 12 electrically connects the first-surface-side connecting member 7 and the first-surface-side electrode 10, and electrically connects the second-surface-side connecting member 8 and the second-surface-side electrode 11.

Here, the first-surface-side connecting member 7 has thereon a facing surface 70 which is a region facing the space Sα, as shown in Fig. 3. The conductive adhesive layer 12 is not formed on the facing surface 70, and the facing surface 70 is exposed to the space Sα. In this embodiment, the facing surface 70 of the first-surface-side connecting member 7 also faces each one end of the first and second solar cells 2-1 and 2-2. However, it is not necessary as long as the facing surface 70 includes a region of a surface of the first-surface-side connecting member 7, the region facing the space Sα.

On the other hand, a region of a surface of the second-surface-side connecting member 8, the region facing the space Sα, is covered with the conductive adhesive layer 12, as shown in Fig. 3.

The first-surface-side protective member 4 is arranged at the side of the first surface A of the solar cell 2 to protect the first surface side of the solar cell module 1.

The second-surface-side protective member 5 is arranged at the side of the second surface B of the solar cell 2 to protect the second surface side of the solar cell module 1.

One of the first-surface-side protective member 4 and the second-surface-side protective member 5 to be arranged on the light-receiving surface side may be made of glass, plastics, or the like having translucency. Meanwhile, the other protective member to be arranged on the back surface side may be made of a resin film, a laminated film having a structure in which a metal foil such as Al foil is sandwiched by a resin film, or the like, in addition to glass or plastics.

The sealing member 6 is provided between the first-surface-side protective member 4 and the second-surface-side protective member 5 to seal the solar cell group 20. For the sealing member 6, a translucent resin material such as EVA, EEA, or PVB, can be used.

Incidentally, a frame such as an Al frame (not shown) can be provided in an outer circumference of the solar cell module 1 having the above-mentioned structure.

### (Structure of Solar Cell)

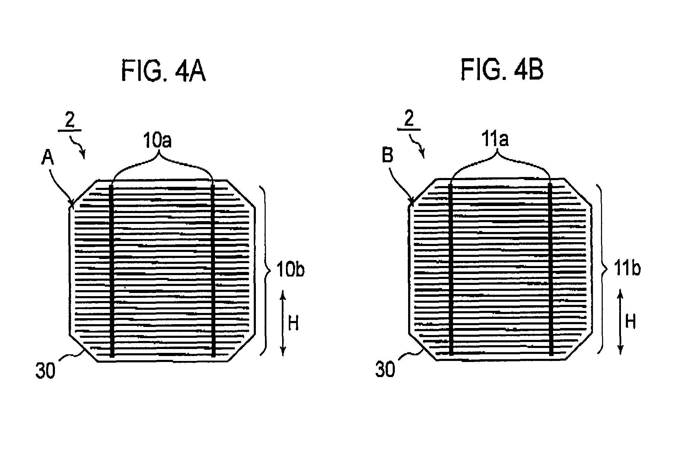

Next, with reference to Figs. 4A and 4B, description will be given of a structure of the solar cell 2. Fig. 4A is a plane view of the first surface A of the solar cell 2, and Fig. 4B is a plane view of the second surface B thereof.

The solar cell 2 includes: the photoelectric conversion part 30; and the first-surface-side electrode 10 and the second-surface-side electrode 11 formed on the first and second surfaces A and B of the photoelectric conversion part 30, respectively.

The first-surface-side electrode 10 has connection electrodes 10a and thin-line electrodes 10b, as shown in Fig. 4A. Meanwhile, the second-surface-side electrode 11 has connection electrodes 11a and thin-line electrodes 11b, as shown in Fig. 4B.

The photoelectric conversion part 30 generates a photogenerated carrier by receiving light. The photogenerated carrier refers to an electron and a hole that are generated by the photoelectric conversion part 30 absorbing sunlight. The photoelectric conversion part 30 has, for example, a p-type region and an n-type region therein, and a semiconductor junction is formed at an interface between the n-type region and the p-type region. The photoelectric conversion part 30 can be formed by using well-known semiconducting materials for solar cells including crystalline silicon semiconductors such as single-crystalline silicon and polycrystalline silicon, and compound semiconductors such as GaAs. Note that, the structure of the photoelectric conversion part 30 is not limited to this, and conventionally-known various structures may be employed instead.

Each thin-line electrode 10b collects carriers from the photoelectric conversion part 30. As shown in Fig. 4A, a plurality of thin-line electrodes 10b is formed on the first surface A of the photoelectric conversion part 30 in a direction intersecting the arrangement direction H.

Each connection electrode 10a is connected to the first-surface-side connecting member 7. The connection electrode 10a is formed on the first surface A of the photoelectric conversion part 30 in the arrangement direction H. Accordingly, the connection electrodes 10a intersect the plurality of thin-line electrodes 10b.

The connection electrode 10a and the thin-line electrode 10b can be formed by using a resin conductive paste, for example, in which a resin material is used as a binder and conductive particles such as silver particles are included. A ceramic conductive paste may be used instead of the resin conductive paste. The number, dimensions, and the like of the connection electrode 10a are set appropriately in consideration of the dimensions, physical properties, and the like of the photoelectric conversion part 30. The number, dimensions, and the like of the thin-line electrode 10b are also set appropriately in consideration of the dimensions, physical properties, and the like of the photoelectric conversion part 30.

As shown in Fig. 4B, each connection electrode 11a has the same structure as that of the connection electrode 10a, and each thin-line electrode 11b has the same structure as that of the thin-line electrode 10b.

Of the first-surface-side electrode 10 and the second-surface-side electrode 11, the electrode arranged on the back surface side opposite to the light-receiving surface side may be formed to cover the whole surface of the back surface.

### (Structure of Solar Cell Group)

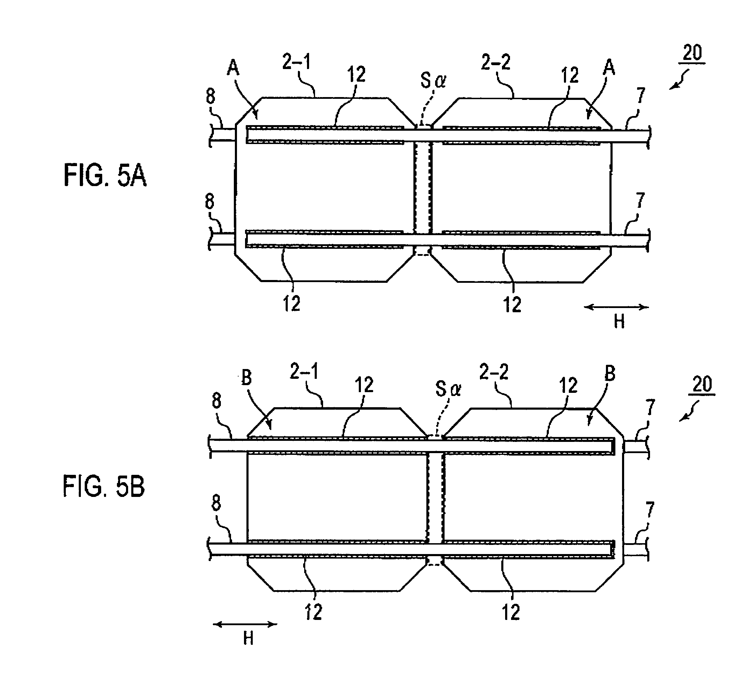

Next, description will be given of a structure of the solar cell group 20. Figs. 5A and 5B are plane views of the solar cell group 20, Fig. 5A is a plane view of the first surface A side, and Fig. 5B is a plane view of the second surface B side. The thin-line electrodes 10b and 11b is omitted in Figs. 5A and 5B.

The first-surface-side connecting member 7 is disposed to extend across the connection electrode 10a of the first solar cell 2-1 and the connection electrode 10a of the second solar cell 2-2. Moreover, the conductive adhesive layer 12 is interposed between the first-surface-side connecting member 7 and each of the connection electrodes 10a and 10a. The conductive adhesive layer 12 is disposed on the connection electrode 10a in the arrangement direction H to bond the connection electrode 10a and the first-surface-side connecting member 7. While the conductive adhesive layer 12 has a width larger than that of the first-surface-side connecting member 7 in Figs. 5A and 5B, the conductive adhesive layer 12 may have a width equal to or smaller than that of the first-surface-side connecting member 7. Additionally, the width of the first-surface-side connecting member 7 is approximately equal to a width of the connection electrode 10a, but it is not limit to this.

The second-surface-side connecting member 8 is disposed on the second surface B of the first solar cell 2-1 and the second solar cell 2-2 so as to extend across the connection electrodes 11a and 11a formed in lines in the arrangement direction H. Moreover, the conductive adhesive layer 12 is interposed between the second-surface-side connecting member 8 and each of the connection electrodes 11a and 11a. The conductive adhesive layer 12 is disposed on the connection electrode 11a in the arrangement direction H to bond the connection electrode 11a and the second-surface-side connecting member 8. While the conductive adhesive layer 12 has a width larger than that of the second-surface-side connecting member 8 in Figs. 5A and 5B, the conductive adhesive layer 12 may have a width equal to or smaller than that of the second-surface-side connecting member 8. Additionally, the width of the second-surface-side connecting member 8 is approximately equal to a width of the connection electrode 11a, but it is not limit to this.

As mentioned above, the conductive adhesive layer 12 is not formed on the surface of the first-surface-side connecting member 7 in the region facing the space Sα. On the other hand, the conductive adhesive layer 12 is formed on the surface of the second-surface-side connecting member 8 in the region facing the space Sα.

### (Method for Manufacturing Solar Cell Module)

Next, description will be given of an example of a method for manufacturing the solar cell module 1 according to this embodiment. Hereinafter, description will be given on the assumption that the first surface A is the light-receiving surface and the second surface B is the back surface.

First, an anisotropic etching process is performed on an n-type single-crystalline silicon substrate using an alkaline solution so that fine projections and depressions called a texture can be formed on the light-receiving surface of the n-type single-crystalline silicon substrate.

Next, using the CVD method (chemical vapor deposition method), an i-type amorphous silicon layer and a p-type amorphous silicon layer are sequentially stacked on the light-receiving surface of the n-type single-crystalline silicon substrate. Similarly, an i-type amorphous silicon layer and an n-type amorphous silicon layer are sequentially stacked on the back surface of the n-type single-crystalline silicon substrate. At this time, each of the i-type amorphous silicon layers formed on the light-receiving surface and back surface of the n-type single-crystalline silicon substrate is formed to have, for example, a thickness of approximately several Å to 250 Å, which is a thickness that does not substantially contribute to generation of electricity.

Next, an ITO film is formed on the light-receiving surface of the p-type amorphous silicon layer using the PVD method (physical vapor deposition method). Similarly, an ITO film is formed on the back surface of the n-type amorphous silicon layer. With the above-mentioned process, the photoelectric conversion part 30 having the first surface A as the light-receiving surface and the second surface B as the back surface is produced.

Next, using a printing method such as a screen printing method, a resin-curing type conductive paste is disposed in a predetermined pattern (see Figs. 4A and 4B) on the light-receiving surface (first surface A) and back surface (second surface B of the photoelectric conversion part 30. Then, the solar cell 2 is produced by heat-curing the conductive paste.

Next, the first and second solar cells 2-1 and 2-2 are arranged in the arrangement direction H. At this time, the space Sα is formed between the first and second solar cells 2-1 and 2-2 by arranging the first and second solar cells 2-1 and 2-2 with the interval α in between.

Next, the connecting members each cut at a predetermined length is prepared. The connecting member is, for example, a sheet of copper whose surface is covered with a conductive adhesive such as solder. The predetermined length is larger than the sum of the lengths of the predetermined interval α, the first and second solar cells 2-1 and 2-2.

Next, the conductive adhesive applied in a region of the surface of one of the connecting members, the region facing the space Sα, is removed. Thereby, the first-surface-side connecting member 7 having the facing surface 70 exposed to the space Sα is formed. The connecting member from which the conductive adhesive is not removed is used as the second-surface-side connecting member 8.

Next, the first-surface-side connecting member 7 is disposed to extend across the connection electrodes 10a of each of the first and second solar cells 2-1 and 2-2. At this time, the facing surface 70 faces the space Sα.

Moreover, the second-surface-side connecting member 8 is disposed to extend across the connection electrodes 11a of each of the first and second solar cells 2-1 and 2-2.

Next, the second-surface-side connecting member 8, the first and second solar cells 2-1 and 2-2, and the first-surface-side connecting member 7 are sequentially placed on a first heater. In other words, in this embodiment, the first-surface-side connecting member 7 having the facing surface 70 is disposed above the first and second solar cells 2-1 and 2-2, while the socond-surface-side connecting member 8 without the facing surface 70 is disposed below the first and second solar cells 2-1 and 2-2.

Next, a second heater is brought into contact with the upper surface of the first-surface-side connecting member 7.

Subsequently, the first-surface-side connecting member 7 and the second-surface-side connecting member 8 are heated by the first heater and the second heater so that the conductive adhesive member may be melted and then solidified. Thereby, the conductive adhesive layer 12 is formed between the first-surface-side connecting member 7 and the connection electrodes 10a and between the second-surface-side connecting member 8 and the connection electrodes 11a. In this manner, the solar cell group 20 is produced.

Then, an EVA sheet (sealing member 6), the plurality of solar cell groups 20 electrically connected to each other, an EVA sheet (sealing member 6), and a PET sheet (second-surface-side protective member 5) are sequentially stacked on a glass substrate (first-surface-side protective member 4) to obtain a stacked body.

Subsequently, the stacked body is thermally compressed in a vacuum atmosphere to cure the EVA. With the above-mentioned process, the solar cell module 1 is manufactured.

Incidentally, a terminal box, an Al frame, or the like can be attached to the solar cell module 1.

### (Operations and Effects)

In the solar cell module 1 according to this embodiment, the first-surface-side connecting member 7 has the facing surface 70 exposed to the space Sα, the first-surface-side connecting member 7 disposed to extend across the connection electrodes 10a of each of the first and second solar cells 2-1 and 2-2 that are arranged with the interval α in between. For this reason, it is possible to suppress the conductive adhesive member, which is melted by heat generated at the time of formation of the conductive adhesive layer 12, from flowing into the space Sα. Accordingly, it is possible to suppress undesirable short circuit and leak attributable to the conductive adhesive member having flowed into the space Sα, and thus to provide the solar cell module capable of improving manufacturing yields.

### (Modification of First Embodiment)

In the manufacturing method mentioned above, description has been given where the first surface A is the light-receiving surface, but not limited to this, the first surface A may be the back surface. In this case, the facing surface 70 may be formed in the second-surface-side connecting member 8, and the second-surface-side connecting member 8 may be disposed above the first and second solar cells 2-1 and 2-2 and heated.

While only the first-surface-side connecting member 7 has the facing surface 70 in this embodiment, in addition to the first-surface-side connecting member 7, the second-surface-side connecting member 8 may have a facing surface having the same structure as that of the facing surface 70. Such a structure can further suppress the melted conductive adhesive member from flowing into the space Sα. As a result, the undesirable short circuit and leak attributable to the conductive adhesive member having flowed into the space Sα can be reduced more reliably.

Alternatively, the facing surface 70 of the first-surface-side connecting member 7 may be covered with a member having a melting point higher than that of the conductive adhesive member. Thereby, it is possible to suppress oxidization of the connecting member from being advanced from the facing surface 70 even when a metal material, such as copper, that easily oxidizes is used as the connecting member. For this reason, the solar cell module 1 having excellent reliability can be provided. Incidentally, for the member having the melting point higher than that of the conductive adhesive member, a material such as polycarbonate, polyethylene terephthalate, or polyphenyl sulfide can be used.

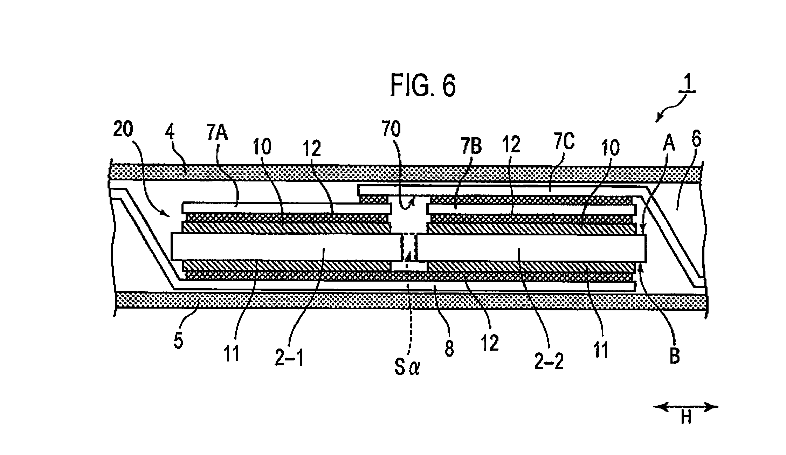

Moreover, in this embodiment, the first-surface-side connecting member 7 is integrally formed with the facing surface 70, but not limited to this, the first-surface-side connecting member 7 and the facing surface 70 may be formed of separate members. Specifically, as shown in Fig. 6, the first-surface-side connecting member 7 may be formed of a first member 7A bonded on the first-surface-side electrode 10 (connection electrodes 10a) of the first solar cell 2-1, a second member 7B bonded on the first-surface-side electrode 10 (connection electrodes 10a) of the second solar cell 2-2, and a third member 7C disposed to extend across the first member 7A and the second member 7B. With such a configuration, the same effects as those of the above-mentioned embodiment can also be obtained.

### [Second Embodiment]

Next, description will be given of a solar cell module according to a second embodiment of the present invention.

This embodiment is different from the first embodiment in that the conductive adhesive member is not melted and solidified on the facing surface 70 of the first connecting member 7. Here, it should be noted that "not melted" mentioned in this embodiment implies not only a state where the conductive adhesive member is not melted at all, but also a state where the conductive adhesive member is slightly melted.

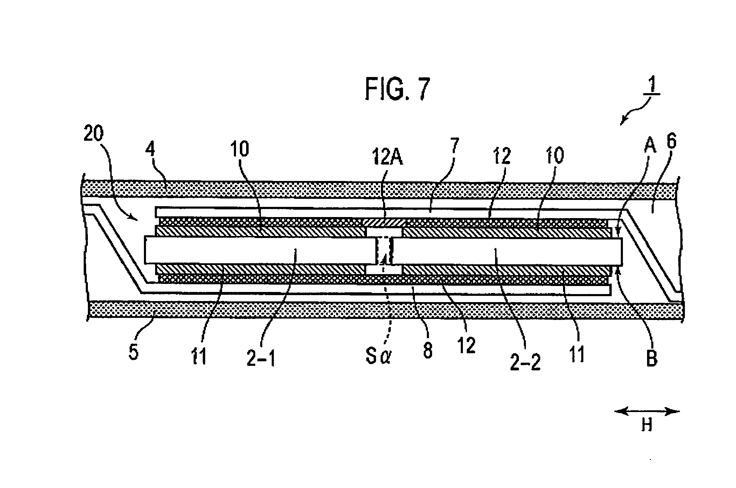

Fig. 7 is an enlarged side view of a solar cell group 20 according to this embodiment. As shown in Fig. 7, a conductive adhesive member 12A is disposed in a region of a surface of a first-surface-side connecting member 7, the region facing a space Sα located between first and second solar cells 2-1 and 2-2. The conductive adhesive member 12A is not melted and solidified.

### (Method for Manufacturing Solar Cell Module)

Next, description will be given of a method for manufacturing a solar cell module according to this embodiment. The same processes as those of the first embodiment are performed until the process to arrange the first and second solar cells 2-1 and 2-2 in an arrangement direction H is completed.

In this embodiment, the first-surface-side connecting member 7 and a second-surface-side connecting member 8 are formed by cutting the connecting member described in the first embodiment. In other words, in this embodiment, the conductive adhesive member 12A is disposed on a facing surface 70 of the first-surface-side connecting member 7.

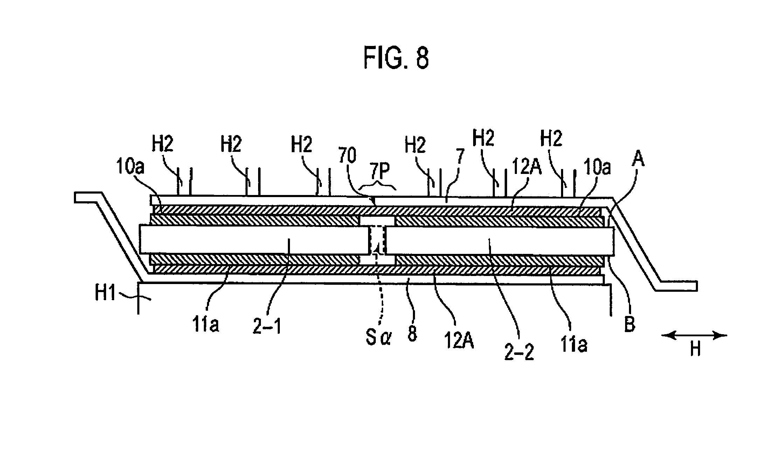

Fig. 8 is an explanatory view for explaining a process of producing the solar cell group 20 according to this embodiment.

First, as shown in Fig. 8, the second-surface-side connecting member 8, the first and second solar cells 2-1 and 2-2, and the first-surface-side connecting member 7 are sequentially placed on a plate-like heater H1. Namely, in this embodiment, the first-surface-side connecting member 7 is disposed above the first and second solar cells 2-1 and 2-2.

Next, a plurality of heaters H2 for local heating which is arranged in the arrangement direction H is brought into contact with the upper surface of the first-surface-side connecting member 7. Note that the heater H2 is not brought into contact with an facing part 7p of the first-surface-side connecting members 7 facing the space Sα. Accordingly, the plurality of heaters H2 is disposed over the first and second solar cells 2-1 and 2-2.

Next, the first-surface-side connecting member 7 and the second-surface-side connecting member 8 are heated with the heater H1 and the plurality of heaters H2, thereby melting and solidifying the conductive adhesive member 12A. Thereby, a conductive adhesive layer 12 is formed between the first-surface-side connecting member 7 and connection electrodes 10a and between the second-surface-side connecting member 8 and connection electrodes 11a.

However, at this time, since the plurality of heaters H2 is not in contact with the facing part 7p of the first-surface-side connecting member 7 facing the space Sα, the facing part 7p is not directly heated. Accordingly, the conductive adhesive member 12A disposed on the facing surface 70 remains without being melted and solidified. Thus, the solar cell group 20 shown in Fig. 7 is produced.

Then, the solar cell module 1 is manufactured by thermally compressing a stacked body in the same manner as in the case of the first embodiment.

### (Operations and Effects)

In the solar cell module 1 according to this embodiment, the conductive adhesive member 12A formed in the region of the surface of the first-surface-side connecting member 7, the region facing the space Sα, is not melted and solidified, the first-surface-side connecting member 7 arranged to extend across the connection electrodes 10a of each of the first and second solar cells 2-1 and 2-2. For this reason, it is possible to suppress the conductive adhesive member 12A, which is melted by heat at the time of formation of the conductive adhesive layer 12, from flowing into the space Sα. Accordingly, it is possible to suppress undesirable short circuit and leak attributable to the conductive adhesive member 12A having flowed into the space Sα, and thus to provide the solar cell module capable of improving manufacturing yields.

Moreover, according to this embodiment, by using the plurality of heaters H2 for local heating, the first-surface-side connecting member 7 is locally heated directly over the first and second solar cells 2-1 and 2-2. In this way, since the facing part 7p of the first-surface-side connecting member 7 is not directly heated, the conductive adhesive member disposed on the facing surface 70 of the first-surface-side connecting member 7 facing the space Sα can remain without being melted. As a result, the melted conductive adhesive member 12A can be effectively suppressed from flowing into the space Sα.

### (Modification of Second Embodiment)

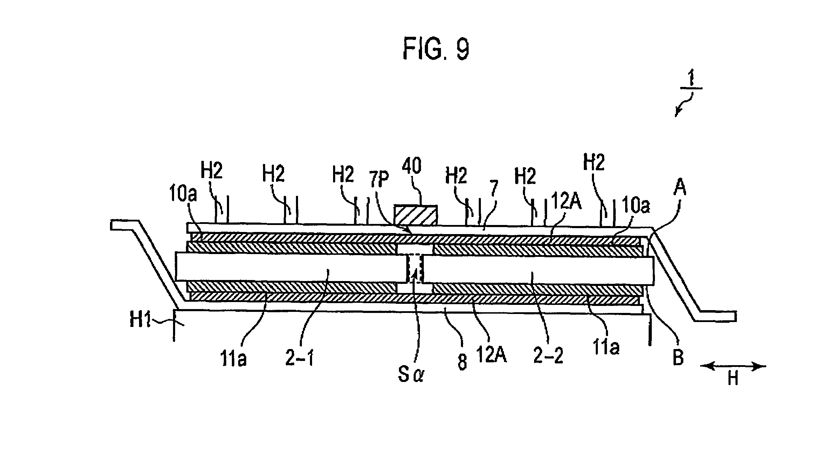

Hereinafter, description will be given of a modification of the second embodiment with reference to the drawings. Fig. 9 is a view for explaining a method for manufacturing a solar cell module 1 according to this modification.

First, the second-surface-side connecting member 8, first and second solar cells 2-1 and 2-2, and the first-surface-side connecting member 7 are sequentially placed on a plate-like heater H1.

Next, plurality of heaters H2 is brought into contact with a portion of the first-surface-side connecting member 7 other than an facing part 7p, and a heat-absorbing body 40 is brought into contact with the facing part 7p. Here, a metal block that can be thermally coupled to the first-surface-side connecting member 7 can be used for the heat-absorbing body 40, for example, but it is not limited to this. The heat-absorbing body 40 has no limitation in its properties or dimensions, as long as the heat-absorbing body 40 can be coupled to the first-surface-side connecting member 7 in a state where heat can be conducted therebetween. However, preferably, a thermal conductivity of the heat-absorbing body 40 is higher than that of the first-surface-side connecting member 7. Moreover, preferably, the heat-absorbing body 40 is not melted by the heat conducted from the facing part 7p.

Next, the first-surface-side connecting member 7 and the second-surface-side connecting member 8 are heated with the heater H1 and the plurality of heaters H2, thereby melting and solidifying the conductive adhesive member 12A. Thereby, a conductive adhesive layer 12 is formed between the first-surface-side connecting member 7 and connection electrodes 10a and between the second-surface-side connecting member 8 and connection electrodes 11a.

Here, in this modification, the plurality of heaters H2 is not in contact with the facing part 7p, and the heat-absorbing body 40 is coupled to the facing part 7p. Accordingly, the heat conducted to the facing part 7p through an inside of the first-surface-side connecting member 7 is absorbed by the heat-absorbing body 40. Accordingly, the conductive adhesive member formed on the surface of the facing part 7p is not melted, and an unmelted conductive adhesive member 12A is formed.

### (Operations and Effects)

In the method for manufacturing the solar cell module 1 according to this modification, when forming the conductive adhesive layer 12 by heating the first-surface-side connecting member 7, the heat-absorbing body 40 is thermally coupled to the facing part 7p.

Accordingly, the heat conducted to the facing part 7p through the inside of the first-surface-side connecting member 7 can be absorbed by the heat-absorbing body 40. Therefore, the conductive adhesive member formed on the surface of the facing part 7p can be further suppressed from being melted. As a result, the melted conductive adhesive member can be effectively suppressed from flowing into a space Sα.

### [Third Embodiment]

Next, description will be given of a solar cell module according to a third embodiment of the present invention.

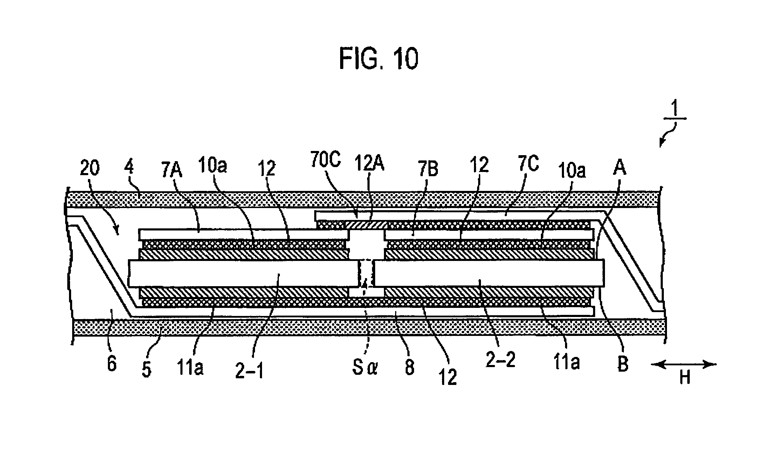

This embodiment is different from the second embodiment in that, unlike the connecting member integrally formed in the second embodiment, separate members are used for the connecting member in this embodiment. Specifically, as shown in Fig. 10, a first-surface-side connecting member 7 is formed of a first member 7A bonded to a first-surface-side electrode 10 (connection electrodes 10a) of a first solar cell 2-1, a second member 7B bonded to the first-surface-side electrode 10 (connection electrodes 10a) of a second solar cell 2-2, and a third member 7C disposed to extend across the first member 7A and the second member 7B.

The first member 7A and the connection electrode 10a are bonded to each other through a conductive adhesive layer 12. The first member 7A and the second member 7B are separated from each other. Accordingly, neither the first member 7A nor the second member 7B faces a space Sα.

The third member 7C is bonded to the first member 7A and the second member 7B through the conductive adhesive layer 12. Additionally, an unmelted conductive adhesive member 12A is formed on a facing surface 70C which is a region of a surface of the third member 7C, the region facing the space Sα. The conductive adhesive member 12A is not melted and solidified.

### (Method for Manufacturing Solar Cell Module)

Next, description will be given of a method for manufacturing the solar cell module according to this embodiment.

The same processes as those of the second embodiment are performed until the process to arrange first and second solar cells 2-1 and 2-2 in an arrangement direction H is completed. Moreover, since a back surface (second surface) side connecting member is the same as that of the second embodiment, description thereof will be omitted here.

A sheet of copper whose surface is covered with the conductive adhesive member 12A made of solder is prepared as the first-surface-side connecting member 7. Then, this connecting member is cut at a first length, and the first member 7A and the second member 7B are produced. The first length is approximately the same length as that of the connection electrode 10a. Furthermore, the connecting member is cut at a second length, and the third member 7C is produced. The second length is longer than that of the second solar cell 2-2 in the arrangement direction H.

Next, a second-surface-side connecting member 8, the first and second solar cells 2-1 and 2-2, and the first and second members 7A and 7B are sequentially placed on a plate-like heater.

Next, a plate-like heater or the plurality of heaters for local heating is brought into contact with the upper surfaces of the first and second members 7A and 7B.

Then, the second-surface-side connecting member 8 and the first and second members 7A and 7B are heated with the heaters, thereby melting and solidifying the conductive adhesive member 12A. Thereby, the conductive adhesive layer 12 is formed between the first and second members 7A and 7B and the connection electrodes 10a and between the second-surface-side connecting member 8 and the connection electrodes 11a.

Subsequently, the third member 7C is disposed to extend across the first and second members 7A and 7B, which are respectively bonded to the first and second solar cells 2-1 and 2-2 on the light-receiving surface side, and is heated with the heater to thereby melt the conductive adhesive member 12A formed on the surface of the third member 7C. At this time, heating by the heater is performed such that only a bonded part of the first and second members 7A and 7B may be locally heated. As mentioned above, neither the first member 7A nor the second member 7B is located at a position facing the space Sα located between the first and second solar cells 2-1 and 2-2. For this reason, the conductive adhesive member 12A formed on the facing surface 70C of the third member 7C remains without being melted and solidified. Thus, a solar cell group 20 according to this embodiment is produced.

Then, by using this solar cell group 20, the solar cell module according to this embodiment is manufactured in the same manner as in the case of the first embodiment.

### (Operations and Effects)

In the solar cell module 1 according to this embodiment, the first-surface-side connecting member 7 for connecting each of the connection electrodes 10a and 10a of the first and second solar cells 2-1 and 2-2 includes the first and second members 7A and 7B respectively bonded to the connection electrodes 10a and 10a, and the third member 7C arranged to extend across the first member 7A and the second member 7B. The third member 7C has the unmelted conductive adhesive member 12A on the facing surface 70C facing the space Sα. For this reason, it is possible to suppress the conductive adhesive member 12A, which is melted by heat at the time of formation of the conductive adhesive layer 12, from flowing into the space Sα. Accordingly, it is possible to suppress undesirable short circuit and leak attributable to the conductive adhesive member having flowed into the space Sα, and thus to provide the solar cell module capable of improving manufacturing yields.

Moreover, according to this embodiment, the third member 7C is bonded on the first and second members 7A and 7B. For this reason, the conductive adhesive member 12A formed on the facing surface 70C can remain unmelted. As a result, the melted conductive adhesive member 12A can be effectively suppressed from flowing into the space Sα.

As has been described above, with the solar cell module and the method for manufacturing the solar cell module according to the present invention, it is possible to suppress the melted conductive adhesive member 12A of the connecting member from flowing into the space Sα. For this reason, according to the present invention, it is possible to minimize potential adverse effects such as undesirable short circuit and leak attributable to the conductive adhesive member having flowed into the space Sα, and thus to provide the solar cell module capable of improving manufacturing yields and the method for manufacturing the solar cell module.

When the first-surface-side connecting member 7 is formed of three members of the first member 7A, the second member 7B, and the third member 7C as in the third embodiment or the modification of the first embodiment, the first-surface-side connecting member 7 has a projecting portion that projects toward the first-surface-side protective member 4 side. In such a case, preferably, a member made of a material having flexibility such as a resin film is used for the first-surface-side protective member 4. With such a structure, pressure to be applied from the first-surface-side protective member 4 to the solar cell 2 through the first-surface-side connecting member 7 at the time of manufacturing the module can be reduced, and thus generation of splits, chips, or cracks in the solar cell 2 can be suppressed. Accordingly, the manufacturing yields can be further improved.

In all the points, the embodiments disclosed herein are merely an exemplification, and should not be considered to limit the present invention. The scope of the present invention is defined by the scope of claims, not by the description of the embodiments mentioned above. Furthermore, all the modifications within the scope of claims and within a sense equivalent to the scope of claims are included.

For example, in the second and third embodiments, an example has been described in which the first-surface-side connecting member has the unmelted conductive adhesive member on the surface facing the interval between the first and second solar cells. However, the present invention is not limited to this, and both of the first-surface-side connecting member and the second-surface-side connecting member may have the unmelted conductive adhesive member on the surfaces facing the interval between the first and second solar cells.

## Claims

1. A solar cell module, comprising:
first and second solar cells each having a main surface and an electrode formed on the main surface; and
a connecting member disposed to extend across the electrode of the first solar cell and the electrode of the second solar cell, wherein
the connecting member is bonded to the electrode of the first solar cell and the electrode of the second solar cell through a conductive adhesive layer, and
the conductive adhesive layer is not formed on a facing surface which is a region of a surface of the connecting member, the facing surface facing a space sandwiched between the first and second solar cells.

2. The solar cell module according to claim 1, wherein the facing surface is exposed to the space.

3. The solar cell module according to claim 2, wherein the facing surface is covered with a member having a melting point higher than that of the conductive adhesive member.

4. The solar cell module according to claim 1, wherein
the conductive adhesive layer is formed by melting and solidifying a conductive adhesive member, and
the conductive adhesive member formed on the facing surface is not melted and solidified.

5. The solar cell module according to claim 2, wherein
the connecting member includes:
a first member disposed on the electrode of the first solar cell;
a second member disposed on the electrode of the second solar cell; and
a third member disposed to extend across the first member and the second member,
the third member is bonded to the first member and the second member through a conductive adhesive layer formed on surfaces of the first member and the second member, and
the facing surface is a region of a surface of the third member, the region facing the space.

6. The solar cell module according to claim 5, further comprising:
a protective member disposed at the main surface side of each of the first and second solar cells, wherein the protective member has flexibility.

7. A method for manufacturing a solar cell module, comprising the steps of:
arranging first and second solar cells at a predetermined interval, each of the first and second solar cells having a main surface and an electrode formed on the main surface;
disposing a connecting member through a conductive adhesive member so as to extend across the respective electrodes of the first and second solar cells; and
bonding the connecting member to the electrode of the first solar cell and the electrode of the second solar cell through a conductive adhesive layer formed by melting and solidifying the conductive adhesive member, wherein
in the bonding step, the conductive adhesive layer is not formed on a facing surface which is a region of a surface of the connecting member, the facing surface facing a space sandwiched between the first and second solar cells.

8. The method for manufacturing a solar cell module according to claim 7, further comprising a step of exposing the facing surface by removing the conductive adhesive member disposed on the facing surface before the bonding step.

9. The method for manufacturing a solar cell module according to claim 7, wherein, in the bonding step, an facing part of the connecting member facing the space is not directly heated.

10. The method for manufacturing a solar cell module according to claim 9, wherein, in the bonding step, a heat-absorbing member is thermally coupled to the facing part.

11. The method for manufacturing a solar cell module according to claim 7, wherein
the arranging step includes the steps of:
disposing a first member through a conductive adhesive member on the electrode of the first solar cell;
disposing a second member through the conductive adhesive member on the electrode of the second solar cell; and
disposing a third member through the conductive adhesive member on the first and second members, and
in the bonding step, the facing surface is a region of a surface of the third member, the region facing the space.

12. The method for manufacturing a solar cell module according to claim 11, further comprising a step of disposing a protective member having flexibility through a sealing member at the main surface side of each of the first and second solar cells after the bonding step.
